# DEMANDE DE BREVET EUROPEEN

(11) **EP 1 067 438 A1**
(43) Date de publication de la demande: **10.01.2001**
(21) Numéro de dépôt: 00401926.1
(22) Date de dépôt: 05.07.2000
(51) Int. Cl.: G03F 9/00

(54) **Installation d'exposition à la lumière d'une carte de circuit imprimé double face**

(30) Priorité: 08.07.1999 FR 9908836
(71) Demandeur: Automa-Tech, 27100 Val de Reuil (FR)
(72) Inventeur: Gilles, Hervé, 27380 Amfreville les Champs (FR); Leboucher, Arnaud, 76000 Rouen (FR)
(74) Mandataire: Dronne, Guy

(57) **Abrégé**

L'invention concerne une installation d'exposition à la lumière d'une plaque de circuit imprimé double face à travers des clichés comprenant un premier support (10) de cliché fixe, un deuxième support de cliché (14) mobile, des moyens de déplacement vertical (26, 28) du deuxième support et des moyens de liaison mécanique entre les moyens de déplacement et le deuxième support, les premier et deuxième supports comportant des organes de positionnement relatif (12, 24) aptes à coopérer entre eux lorsque les deux supports sont en position de travail.

Les moyens de liaison mécanique comprennent une première surface horizontale de liaison (42, 44) reliée mécaniquement (38, 40, 46, 48) aux moyens de déplacement vertical ; une deuxième surface horizontale (20, 22) de liaison solidaire du deuxième support ; des moyens de supportage (50) pour réaliser une coopération sensiblement sans frottement entre les première (42, 44) et deuxième (20, 22) surfaces de liaison ; et des moyens (50) commandables de solidarisation temporaire des première et deuxième surfaces de liaison.

## Description

La présente invention a pour objet une installation d'exposition à la lumière d'une carte de circuit imprimé double face.

On sait que parmi les opérations nécessaires à la réalisation d'une carte de circuit imprimé, il intervient une étape d'insolation, notamment pour la définition par photogravure des pistes conductrices du circuit imprimé. L'installation correspondante a pour fonction d'exposer aux ultraviolets, pendant un temps donné, les circuits imprimés recouverts d'un film ou d'une laque photosensible à travers un cliché pour insoler la partie correspondante de la laque ou du film photosensible.

L'installation considérée est du type dans lequel le circuit imprimé est du type double face, c'est-à-dire que des pistes conductrices doivent être réalisées sur les deux faces du support isolant du panneau de circuit imprimé, ces deux faces étant réalisées simultanément.

En conséquence, dans une telle installation, on va trouver un support supérieur de cliché et un support inférieur de cliché entre lesquels on dispose le panneau dont les deux faces doivent être insolées. Pour permettre la mise en place du panneau à insoler, il est nécessaire de pouvoir écarter le support supérieur de cliché par rapport au support inférieur. Ces supports de cliché sont montés sur des cadres et le support supérieur est donc associé à un cadre supérieur qui doit pouvoir être animé d'un mouvement de montée et de descente.

De telles installations sont notamment décrites dans les demandes de brevet européen EP 0 618 505 et EP 0 807 855 au nom de la Demanderesse.

Lorsque le cadre du cliché supérieur arrive en position basse, celui-ci est positionné rigoureusement par rapport au cadre inférieur par la présence de cônes de centrage, respectivement mâle et femelle, constitués par des cônes positifs et négatifs. Il est nécessaire que cette opération puisse être répétée avec une grande précision de l'ordre de 5 microns.

Lorsque les panneaux de circuit imprimé à réaliser, c'est-à-dire à insoler sur leurs deux faces, ont des dimensions relativement réduites, la coopération entre les cônes mâles et femelles du cadre mobile supérieur et du cadre fixe inférieur peut être obtenu relativement aisément. En revanche, dans le cas de panneaux de circuit imprimé de plus grandes dimensions, il est nécessaire de prévoir une machine qui elle-même est de plus grande dimension et dont le cadre supérieur présente des dimensions plus importantes et en conséquence, un poids bien plus élevé, par exemple 250 kg, notamment pour obtenir la rigidité nécessaire à la précision de l'insolation. Dans ce cas, lors de l'abaissement du cadre supérieur par rapport au cadre inférieur, la coopération entre les cônes mâles et femelles du cadre supérieur et du cadre inférieur soulève un certain nombre de difficultés, notamment dû à des problèmes de frottement entre les cônes mâles et femelles.

Un objet de la présente invention est de fournir une installation d'exposition à la lumière d'une plaque de circuit imprimé double face à travers des clichés dans laquelle la coopération des cônes mâles et femelles du cadre supérieur portant le cliché supérieur et du cadre inférieur pourra être obtenue aisément malgré le poids important du cadre supérieur mobile.

Pour atteindre ce but selon l'invention, l'installation d'exposition à la lumière d'une plaque de circuit imprimé double face à travers des clichés comprenant un bâti, un premier cadre pour support de cliché fixe par rapport au bâti, un deuxième cadre pour support de cliché mobile par rapport au bâti, des moyens de déplacement vertical pour déplacer ledit deuxième cadre entre une position d'attente et une position de travail dans laquelle les deux cadres sont proches l'un de l'autre et des moyens de liaison mécanique entre les moyens de déplacement et ledit deuxième cadre, les premier et deuxième cadres comportant des organes de positionnement relatif aptes à coopérer entre eux lorsque les deux cadres sont en position de travail, se caractérise en ce que lesdits moyens de liaison mécanique comprennent :
- des premiers moyens formant une première surface horizontale de liaison reliés mécaniquement aux moyens de déplacement vertical ;
- des moyens formant une deuxième surface horizontale de liaison solidaire dudit deuxième cadre ;
- des moyens de supportage ou de sustentation pour réaliser une coopération sensiblement sans frottement dans un plan horizontal entre lesdites première et deuxième surfaces de liaison, par quoi ledit deuxième cadre peut être déplacé horizontalement par rapport au bâti ; et
- des moyens commandables de solidarisation temporaire desdites première et deuxième surfaces de liaison.

On comprend que grâce au mode de liaison entre les moyens de déplacement vertical du cadre et le cadre lui-même, il est possible d'obtenir la coopération des cônes mâles et femelles de positionnement sans introduire de contraintes importantes. En revanche, en dehors de la phase finale de coopération entre les cônes, les moyens de solidarisation temporaire permettent d'assurer une liaison rigide entre les moyens de déplacement et le cadre du support de cliché supérieur lui-même.

De préférence, entre les moyens de coopération sans frottement et les moyens de déplacement, on interpose des moyens pneumatiques commandables à déplacement vertical pour provoquer un déplacement relatif vertical entre le cadre supérieur et les moyens de déplacement vertical. Cette disposition permet de "soulager" ou réduire le poids apparent du cadre supérieur muni du support de cliché supérieur pour réaliser ainsi une fonction de sécurité vis-à-vis du personnel amené à utiliser cette machine. On rappelle en effet que, l'ensemble du cadre supérieur peut avoir un poids de l'ordre de 250 kg. Elle permet également de soulager le cadre supérieur au moment où il arrive en contact avec le cadre inférieur. On peut ainsi limiter les contraintes appliquées au cadre inférieur lors de ce contact. En revanche, lorsque le cadre supérieur arrive en contact avec le cadre inférieur, il est nécessaire que le poids apparent du cadre soit suffisant pour vaincre l'effort développé par le joint gonflable qui est prévu sur le cadre inférieur pour permettre de faire le vide entre ces deux cadres.

De préférence encore, les moyens de coopération sensiblement sans frottement comprennent des billes qui sont interposées entre les première et deuxième surfaces horizontales de liaison.

D'autres caractéristiques et avantages de l'invention apparaîtront mieux à la lecture de la description qui suit d'un mode préféré de réalisation de l'invention donné à titre d'exemple non limitatif. La description se réfère aux figures annexées sur lesquelles :
- la figure 1 est une vue schématique en perspective montrant la liaison entre les moyens de déplacement et le cadre supérieur ;
- la figure 2 est une vue détaillée en élévation et en coupe de l'ensemble de la machine d'exposition ;
- la figure 3 est une vue partielle de la figure 2 ;
- la figure 4 est une vue de détail montrant la réalisation du supportage sans frottement et du verrouillage du cadre supérieur sur les moyens de déplacement ; et
- la figure 5 est une vue de détail montrant la coopération entre les moyens pneumatiques et les éléments de déplacement vertical du cadre supérieur.

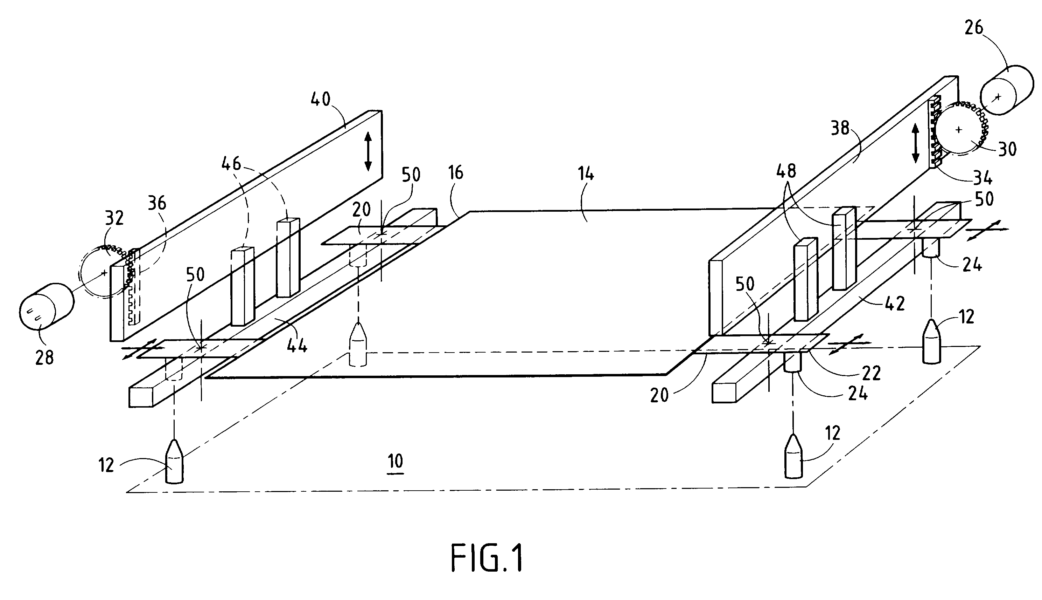

En se référant tout d'abord plus particulièrement à la figure 1, on va exposer les caractéristiques essentielles de l'installation d'exposition selon l'invention.

Sur cette figure, on a représenté de façon simplifiée le cadre inférieur 10 qui est fixé avec ses cônes mâles de positionnement 12. Sur cette figure, on a également représenté le cadre supérieur 14 qui est muni à chacune de ses extrémités longitudinales 16 et 18 d'une paire d'oreilles telles que 20 qui se projettent hors du cadre supérieur 14. L'extrémité 22 de chacune des oreilles 20 comporte un cône femelle 24 de centrage qui doit coopérer avec les cônes mâles 12 du cadre inférieur 10. Les oreilles 20 étant rigidement reliées au cadre 14, les cônes femelles 24 sont également reliés rigidement au cadre supérieur 14 et permettent donc le positionnement rigoureux de celui-ci par rapport au cadre inférieur 10, lorsque les cônes 24 et 12 coopèrent.

Le cadre supérieur 14 est relié aux moyens de déplacement verticaux par l'intermédiaire des oreilles 20. Plus précisément, ces moyens de déplacement comportent deux ensembles moto-réducteurs 26 et 28 qui sont montés sur le bâti de la machine non représenté sur la figure 1. La sortie des moto-réducteurs 26, 28 est couplée à un pignon 30, 32 qui coopère avec une crémaillère 34, 36 ménagée respectivement dans des plaques support 36 et 38 qui sont disposées à chaque extrémité longitudinale du cadre supérieur 14. C'est grâce aux moto-réducteurs 26 et 28 et au système pignon crémaillère que les plaques 36 et 38 peuvent donc être déplacées verticalement de façon synchronisée. La liaison mécanique entre les moyens de déplacement et le cadre supérieur 14 comporte également des poutres 42 et 44 disposées parallèlement aux plaques 38 et 40. Les poutres 44 et 42 sont raccordées aux plaques 38 et 40 par deux ensembles de vérins pneumatiques 46 et 48 qui seront décrits plus en détail ultérieurement. Il suffit d'indiquer que ces vérins permettent d'obtenir un déplacement relatif commandable entre les poutres 42, 44 et les plaques 38 et 40.

Les extrémités 22 des oreilles 20 du cadre supérieur 14 sont raccordées chacune aux poutres 42 et 44 par l'intermédiaire d'un système 50 de supportage sans frottement et de verrouillage temporaire. En d'autres termes, lorsque les moyens de verrouillage temporaire ne sont pas activés, les oreilles 20 et donc le cadre supérieur 14 peut se déplacer librement dans un plan horizontal par rapport aux poutres 42 et 44, c'est-à-dire par rapport aux moyens de déplacement vertical du cadre supérieur 14. Les systèmes de supportage sans frottement 50 et de verrouillage seront décrits plus en détail ultérieurement.

On va maintenant décrire le mode de fonctionnement de l'installation d'insolation, du moins en ce qui concerne le positionnement du cadre supérieur 14 par rapport au cadre inférieur 10. Dans la phase initiale de descente du cadre 14, les systèmes 50 de verrouillage sont activés. Ainsi, le cadre supérieur 14 est rigidement relié aux moyens de déplacement vertical du cadre 14. Lorsque les cônes de centrage 24 du cadre supérieur arrivent à proximité immédiate des cônes mâles 12 du cadre inférieur 10, les moyens de verrouillage des systèmes 50 sont désactivés de telle manière que le cadre supérieur 14 puisse se déplacer librement dans le plan horizontal par rapport aux moyens de déplacement vertical. Ainsi, en terminant l'abaissement du cadre supérieur 14, on obtient la coopération finale des cônes de centrage sans introduire de contrainte dans le système mécanique et en obtenant une précision de positionnement relatif très élevé.

Il faut ajouter que dans la phase de descente, les vérins pneumatiques 46 sont activés pour provoquer le soulagement du cadre supérieur 14 par rapport aux moyens de déplacement. Ce n'est que lorsque le positionnement a été réalisé que les vérins 46 sont activés pour conférer au cadre supérieur un poids relatif suffisant.

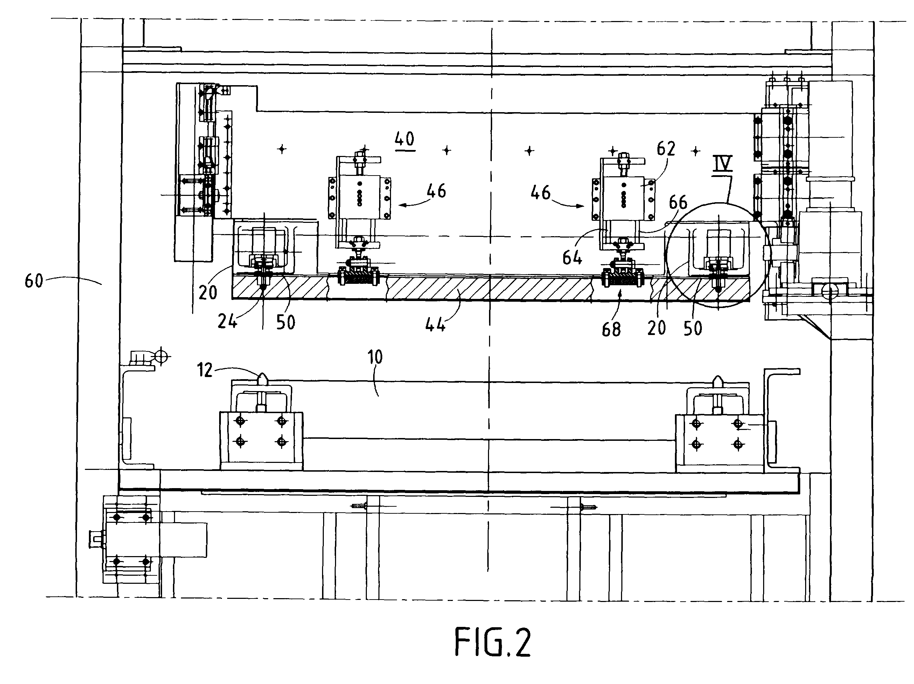

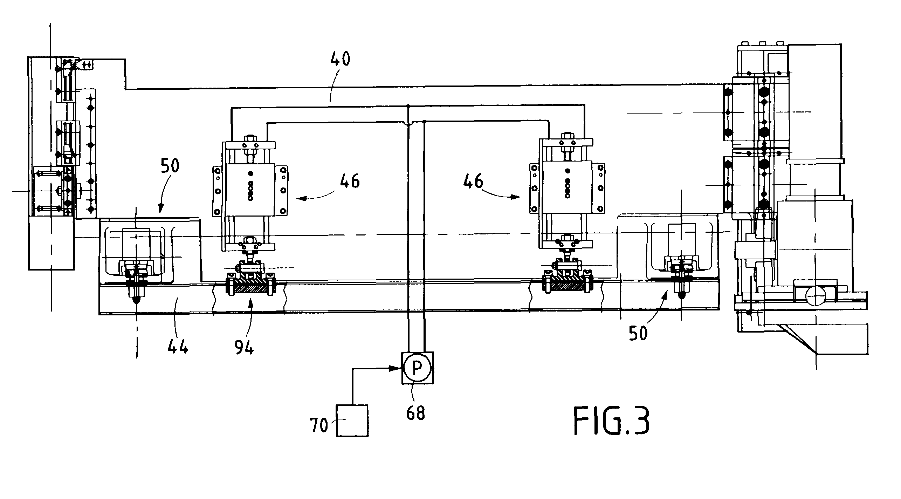

Les figures 2 et 3 montrent plus en détail les différents organes qui ont été déjà décrits en liaison avec la figure 1. Ces figures font en particulier apparaître le bâti 60 de l'ensemble de la machine qui supporte le cadre inférieur 12 et qui sert de guidage vertical pour le déplacement des plaques 38 et 40. Sur ces figures, on a également représenté plus en détail les vérins 46. De préférence, chaque vérin comporte un corps unique 62 qui commande les déplacements de deux tiges de vérin 64 et 66 parallèles entre elles. Les extrémités des tiges 64 et 66 sont accouplées à la poutre 44 par un système de liaison qui sera décrit ultérieurement en liaison avec la figure 5.

Sur la figure 3 ont a également représenté le régulateur de pression 68 qui est reliée au vérin 46. Le régulateur 68 est associé à un circuit de commande 70 qui permet de contrôler le niveau de pression appliqué au vérin et donc de commander le "soulagement" du cadre supérieur ou au contraire son application avec pression sur le cadre inférieur.

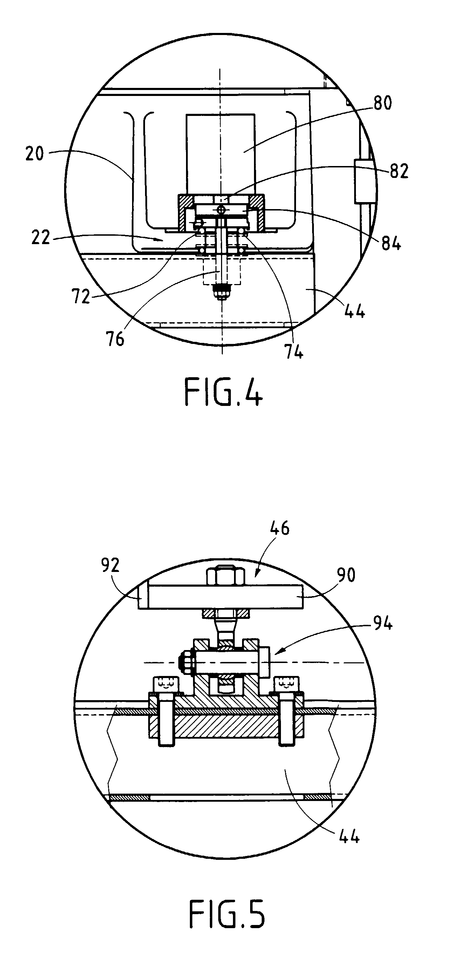

Sur la figure 4, on a représenté plus en détail la liaison mécanique entre une oreille 20 du cadre supérieur et la poutre 44 par l'intermédiaire du système 50 de supportage sans frottement et de verrouillage. Le système de supportage 22 est essentiellement constitué par des billes, telles que 72, qui sont disposées dans une cage, dont le premier élément est une surface horizontale plane 74 prévue dans l'oreille 20 et dont l'autre partie est constituée par une plaque également horizontale 75 qui est reliée à la poutre 44 par une tige 76 qui traverse librement l'oreille 20. Ainsi, l'oreille 20 peut se déplacer librement et sans frottement par rapport à la poutre 44 dans un plan horizontal. Pour réaliser le verrouillage et donc une immobilisation du cadre supérieur 14 par rapport à la poutre 44, on a prévu, solidaire de l'oreille 20, un vérin 80 dont la tige 82 se termine par une plaque 84 en regard de la plaque 74 du système à billes. On comprend qu'en activant le vérin 80, la plaque 84 est appliquée avec pression sur la plaque supérieure 74, ce qui entraîne une immobilisation des billes et donc la liaison rigide entre un cadre supérieur et la poutre 44.

Sur la figure 5, on a représenté un mode préféré de liaison mécanique entre les tiges des vérins 46 solidaires de la plaque 38 et la poutre 42. Cette liaison comprend une barre 90 solidaire de l'extrémité inférieure des tiges du vérin 46. Cette barre 90 est reliée à la poutre 44 par une liaison articulée 94 dont l'axe est parallèle à la poutre 44.

## Revendications

1. Installation d'exposition à la lumière d'une plaque de circuit imprimé double face à travers des clichés comprenant un bâti, un premier cadre pour support de cliché fixé par rapport au bâti, un deuxième cadre pour support de cliché mobile par rapport au bâti, des moyens de déplacement vertical pour déplacer ledit deuxième cadre entre une position d'attente et une position de travail dans laquelle les deux cadres sont proches l'un de l'autre et des moyens de liaison mécanique entre les moyens de déplacement et ledit deuxième cadre, les premier et deuxième cadres comportant des organes de positionnement relatif aptes à coopérer entre eux lorsque les deux cadres sont en position de travail,
caractérisée en ce que lesdits moyens de liaison mécanique comprennent :
- des premiers moyens formant une première surface horizontale de liaison reliés mécaniquement aux moyens de déplacement vertical ;
- des moyens formant une deuxième surface horizontale de liaison solidaire dudit deuxième cadre ;
- des moyens de supportage ou de sustentation pour réaliser une coopération sensiblement sans frottement dans un plan horizontal entre lesdites première et deuxième surfaces de liaison, par quoi ledit deuxième cadre peut être déplacé horizontalement par rapport au bâti ; et
- des moyens commandables de solidarisation temporaire desdites première et deuxième surfaces de liaison.

2. Installation d'exposition à la lumière selon la revendication 1, caractérisée en ce que ladite première surface de liaison horizontale est reliée auxdits moyens de déplacement vertical par des moyens mécaniques comprenant des moyens pneumatiques commandables à déplacements verticaux aptes à provoquer un déplacement relatif vertical entre ledit deuxième cadre et lesdits moyens de déplacement vertical.

3. Installation d'exposition à la lumière selon l'une quelconque des revendications 1 et 2, caractérisée en ce que lesdits moyens de coopération sensiblement sans frottement comprennent des billes interposées entre lesdites première et deuxième surfaces horizontales de liaison.

4. Installation d'exposition à la lumière selon l'une quelconque des revendications 1 à 3, caractérisée en ce que lesdits moyens pneumatiques commandables comprennent une pluralité de vérins dont le corps est solidaire d'une première pièce reliée mécaniquement auxdits moyens de déplacement vertical et dont l'extrémité de la tige à déplacement vertical est solidaire d'une deuxième pièce elle-même solidaire des moyens formant la deuxième surface d'appui.

5. Installation selon la revendication 3, caractérisée en ce que ledit deuxième cadre mobile est le cadre supérieur, en ce que ladite première surface horizontale de liaison est disposée au-dessus de ladite deuxième surface horizontale de liaison et en ce que lesdits moyens commandables de solidarisation comprennent une pluralité de vérins à déplacement vertical dont la partie mobile peut prendre une première position dans laquelle elle est écartée de ladite première surface de liaison et une deuxième position dans laquelle elle exerce une pression sur ladite première surface de liaison, par quoi lesdites billes sont immobilisées entre lesdites première et deuxième surfaces de liaison.
